# EUROPEAN PATENT APPLICATION

(11) **EP 4 535 401 A1**
(43) Date of publication of application: **09.04.2025**
(21) Application number: 23201642.8
(22) Date of filing: 04.10.2023
(51) Int. Cl.: H01L 21/20, H01L 21/02

(54) **2D MATERIAL STACK FORMATION**

(71) Applicant: Imec VZW, 3001 Leuven (BE); Katholieke Universiteit Leuven, 3000 Leuven (BE)
(72) Inventor: MORIN, Pierre, 1150 Woluwe-Saint-Pierre (BE); GROVEN, Benjamin, 3724 Kortessem (BE); VORONENKOV, Vladislav, 3000 Leuven (BE)
(74) Representative: Winger

(57) **Abstract**

A method for forming a stack of two or more layers, the method comprising: a) providing: a flat surface (1), a first set of walls (3), comprising a first wall (31) and a second wall (32), in physical contact with the flat surface (1), and meeting at a corner (312) to form an angle, and a first layer (2) formed of a two-dimensional material in physical contact with the flat surface (1) and with both the first (31) and second walls (32) at the corner (312), wherein the angle is adapted to align with the crystal structure of said two-dimensional material with a tolerance of up to 5°, wherein a top surface (22) of the first layer (2) is exposed,
wherein each of the walls (31, 32) has a length of from 5 nm to 1000 nm, wherein a height of the walls (31, 32), as measured from the exposed top surface (22) of the first layer (2) to a top (30) of the walls (31, 32), is from 0.6 nm to 2 nm, thereby forming a cavity delimited at least by the top surface (22) and the first set of walls (3), then b) forming a second layer (4, 7) in the cavity and in physical contact with the exposed top surface (22) of the first layer (2).

## Description

### Technical field of the invention

The present invention relates to the field of two-dimensional materials, such as transition metal dichalcogenide crystals, and more particularly to the formation of stacks of layers comprising such two-dimensional materials.

### Background of the invention

New computing-intensive applications such as Internet of Things (IoT) and artificial intelligence (Al), require extreme energy efficiency and a concomitant improvement of cost performance of the electronic systems. Modern computer processors are built on field-effect transistors (FETs). Since the 1960s, the number of transistors in a typical microprocessor has followed an exponential growth, a trend known as Moore's law. More transistors are integrated in a single chip with much improved performance and reduced cost, by making the transistor smaller. However, as silicon transistors enter the sub-10nm technology node, channel performance drastically reduces limiting further device scaling.

Therefore, it becomes increasingly important to explore alternative device geometries or new channel materials. Atomically thin two-dimensional materials, in particular two-dimensional (2D) semiconductors, have attracted tremendous interest as new channel materials that could facilitate continued transistor scaling. To benefit from continuous scaling, the scaled two-dimensional transistors needs to outperform silicon technology at similar device dimensions.

In theory, transition metal dichalcogenides (MX₂, where M and X stand for a transition metal and a chalcogen respectively) is a family of materials that could succeed in this task.

However, the deposition of two-dimensional materials with control over the crystalline structure, morphology and material properties remains a challenge.

Furthermore, it is expected that performance may be improved when the channel comprises a stack of two or more layers of two-dimensional materials, e.g., transition metal dichalcogenides, in particular when the two-dimensional materials are aligned, i.e., have a same orientation. In addition, hetero-stacks comprising layers of two-dimensional materials, preferably having a same orientation, alternated with layers of another material, e.g., a dielectric material, may improve interface properties between the layers of two-dimensional materials.

There is thus still a need in the art for devices and methods that address at least some of the above problems.

### Summary of the invention

It is an object of the present invention to provide a good method for forming a stack of two or more layers comprising at least a first layer formed of a two-dimensional material.

It is a further object of the present invention to provide a good structure comprising a stack of two or more layers comprising at least a first layer formed of a two-dimensional material.

In a first aspect, the present invention relates to a method for forming a stack of two or more layers, the method comprising:
a) providing:
   a flat surface,
   a first set of walls, comprising a first wall and a second wall, in physical contact with the flat surface, and meeting at a corner to form an angle, and
   a first layer formed of a two-dimensional material in physical contact with the flat surface and with both the first and second walls at the corner,

   wherein the angle is adapted to align with the crystal structure of said two-dimensional materials with a tolerance of up to 5°,
   wherein a top surface of the first layer is exposed,
   wherein each of the walls has a length of from 5 nm to 1000 nm, wherein a height of the walls, as measured from the exposed top surface of the first layer to a top of the walls, is from 0.6 nm to 2 nm, thereby forming a cavity delimited at least by the top surface and the first set of walls, then
b) forming a second layer in the cavity and in physical contact with the exposed top surface of the first layer.

In a second aspect, the present invention relates to a structure comprising:
a flat surface,
a first set of walls, comprising a first wall and a second wall, in physical contact with the flat surface, and meeting at a corner to form an angle, and
a first layer formed of a two-dimensional material in physical contact with the flat surface and with both the first and second walls at the corner,
wherein the angle is adapted to align with the crystal structure of said two-dimensional materials with a tolerance of up to 5°,
wherein each of the walls has a length of from 5 nm to 1000 nm, wherein a height of the walls, as measured from a top surface of the first layer to a top of the walls, is from 0.6 nm to 2 nm, thereby forming a cavity delimited at least by the top surface and the first set of walls, and
a second layer in the cavity and in physical contact with the top surface of the first layer.

It is an advantage of embodiments of the present invention that two-dimensional materials, contained in a stack, having a unidirectional in-plane orientation can be obtained.

It is an advantage of embodiments of the present invention that the precise location of a stack comprising high quality crystals of a two-dimensional material on a substrate can be set, thereby enabling the fabrication of a device at that precise location.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1A to FIG. 7A, and FIG. 1B to FIG. 7B are schematic representations of a top view and a vertical cross-section, respectively, of a structure in subsequent steps in a first example of a method in accordance with embodiments of the present invention.
FIG. 8A to FIG. 10A, and FIG. 8B to FIG. 10B are schematic representations of a top view and a vertical cross-section, respectively, of a structure in subsequent steps in a second example of a method in accordance with embodiments of the present invention.
FIG. 11A, FIG. 11B, FIG. 11C and FIG. 1D are, each, a schematic representation of a top view of a first layer and a set of walls, in embodiments of the present invention.
FIG. 12 to FIG. 16 are schematic representations of a vertical cross-section of a structure in accordance with embodiments of the present invention, in subsequent steps for forming a nanosheet field effect transistor, comprising a nanosheet formed from a stack of layers in accordance with embodiments of the present invention is formed.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

In the context of the present invention, when reference is made to a crystal structure of a material, the ordered arrangement of atoms, ions, or molecules in said material is meant. The arrangement may be independent of the type of atoms, ions, or molecules: for example, both graphene and boron nitride may have a hexagonal crystal structure and, thus, may have the same crystal structure, even though the atoms or ions making up these materials are different. When referring to a particular crystal structure of a two-dimensional material, reference may be made to the corresponding 2D Bravais lattices, which are grouped into five corresponding lattice systems. For example, when referring to an orthorhombic crystal structure, reference is made to the orthorhombic lattice system, comprising the rectangular and centered rectangular 2D Bravais lattices. An angle adapted to align with this crystal structure is 90°. For example, when referring to a monoclinic crystal structure, reference is made to the monoclinic lattice system comprising the oblique 2D Bravais lattice. An angle adapted to align with this crystal structure is 90°. For example, when referring to a tetragonal crystal structure, reference is made to the tetragonal lattice system comprising the square 2D Bravais lattice. An angle adapted to align with this crystal structure is 90°. For example, when referring to a hexagonal crystal structure, reference is made to the hexagonal lattice system comprising the hexagonal 2D Bravais lattice. An angle adapted to align with this crystal structure is, e.g., 60°.

As used herein, and unless provided otherwise, a two-dimensional material refers to a crystalline material sufficiently thin to exhibit properties distinct from its bulk counterpart wherein each layer is formed of unit cells which are repeated in two spatial dimensions but not in the third dimension. Sufficiently thin typically means comprising from one to ten layers. Typically, the two-dimensional material has a thickness of at most 5 nm. The two-dimensional materials are typically formed of layers of homo-atoms or hetero- atoms arranged in layers with stronger bonds within a layer than between layers of the material. Examples of two-dimensional material are graphene, hexagonal boron nitride, phosphorene, transition metal dichalcogenides, transition metal oxides, graphene oxide, fluorographene, germanene, graphane, graphyne, borophene, silicene, and stanene.

In a first aspect, the present invention relates to a method for forming a stack of two or more layers, the method comprising:
a) providing:
   a flat surface,
   a first set of walls, comprising a first wall and a second wall, in physical contact with the flat surface, and meeting at a corner to form an angle, and
   a first layer formed of a two-dimensional material in physical contact with the flat surface and with both the first and second walls at the corner,

   wherein the angle is adapted to align with the crystal structure of said two-dimensional material with a tolerance of up to 5°,
   wherein a top surface of the first layer is exposed,
   wherein each of the walls has a length of from 5 nm to 1000 nm, wherein a height of the walls, as measured from the exposed top surface of the first layer to a top of the walls, is from 0.6 nm to 2 nm, thereby forming a cavity delimited at least by the top surface and the first set of walls, then
b) forming a second layer in the cavity and in physical contact with the exposed top surface of the first layer.

The corner at which the first a wall and the second wall meet is the corner formed by both walls touching each other.

In embodiments, the corner has a radius of curvature of at most 5 nm, preferably at most 1 nm. The radius of curvature is a radius of a circle that best fits the surface of the corner. Ideally, the surface of the corner forms an infinitely sharp angle, i.e., its radius of curvature is 0 nm. In practice, however, the surface of the corner may have a curvature. This curvature is preferably at most 5 nm and more preferably at most 1 nm.

In embodiments, at least 50%, preferably at least 60%, more preferably at least 70%, even more preferably at least 80%, yet more preferably at least 90%, by area, of a cross-section of the first layer, parallel to the flat surface, intersects with a single crystal of the two-dimensional material, wherein said single crystal contacts the corner. In these embodiments, alignment of a crystal in any further layers of a two-dimensional material, formed over the single crystal of the first layer of a two-dimensional material, may be ensured. The method of the present invention facilitates the formation of a stack of layers comprising a plurality of layers of a two-dimensional material, possibly alternating with layers formed of another material (e.g., an amorphous material), wherein the crystals, e.g., the single crystals, of the two-dimensional materials of the plurality of layers have a same orientation.

In a first type of embodiments, step b comprises growing the second layer formed of a two-dimensional material in physical contact with the exposed top surface of the first layer, the second layer contacting the first and second wall of the first set.

In preferred embodiments, the two-dimensional material of the first layer and the second layer have a same crystal structure. In preferred embodiments, the two-dimensional material of the second layer and the two-dimensional material of the first layer are the same. In these embodiments, the cavity favours the growth of a monocrystalline two-dimensional material layer therein. Without being bound by theory, it is believed that the angle of the corner being adapted to align with the crystal structure of the two-dimensional materials with a tolerance of up to 5°, induces the growth of the crystal of the second layer in that corner and/or induces the seamless coalescence of crystals growing on a same wall or on different walls forming the cavity. Also, it is believed that by keeping the walls short, i.e., at most 1000 nm, the atoms contacting the surface between the walls find themselves frequently at a shorter distance from a wall than their diffusion length, which would favour the nucleation and ripening of few or even of only one nucleus. For longer walls, it becomes increasingly likely that the second layer of the two-dimensional material formed between the walls will be polycrystalline. Also, it is believed that by keeping the walls low, the growth of a crystal vertically, i.e., parallel to and on a wall, is prevented. In embodiments, the angle being adapted to align with the crystal structure may mean that the angle is designed to match the angle between adjacent atoms in the crystal lattice. Herein, a discrepancy of up to 5° is allowed.

Typically, the two-dimensional material of the second layer is grown by depositing a precursor species, comprising the atoms from which the two-dimensional material of the second layer is to be formed, on the top surface of the first layer. The precursor species are adsorbed and may diffuse on the top surface of the first layer. The two-dimensional material of the second layer may be grown by the diffusing precursor species contacting, and reacting with, each other. Alternatively, the diffusing precursor species may react in the gas phase, and then be adsorbed and diffuse on the top surface of the first layer.

In embodiments, a critical dimension of the cavity, in the plane of the top surface of the first layer, is at most equal to the mean diffusion length of the adsorbed precursor species. The critical dimension is typically the length of the longest straight line that may be contained in the cavity. For example, the critical dimension may be the distance between distal ends, away from the corner, of the first and second wall. In these embodiments, growth of the two-dimensional material of the second layer may favourably proceed from a few nuclei or even from a single nucleus. For longer critical dimensions, it becomes increasingly likely that a polycrystalline two-dimensional material is formed.

In embodiments of the first type, step b) may be performed by chemical vapor deposition, for example, by metal-organic chemical vapor deposition, such as by HCl, Cl₂ or H₂O assisted metal-organic chemical vapor deposition. For instance, step b can be performed by chemical vapor deposition from a metal-organic or metal-halide (e.g., W(CO)₆, WCl₆) and from a sulphur precursor (e.g., H₂S, elemental S). Chemical vapor deposition is advantageous as it allows tuning of the diffusion length in the range of from 10 nm to beyond 1000 nm across a wide range of deposition temperatures. The deposition temperature may be an important parameter, as it may determine the thermal and chemical compatibility of the chemical vapor deposition with components of the structure, e.g., with the type and chemical composition of the flat surface and of the walls.

In embodiments of the first type, step b) may be performed by atomic layer deposition. Atomic layer deposition is particularly advantageous when each of the walls of the first set has a length of from 5 nm to 50 nm.

In embodiments, the first wall material comprises a dielectric, e.g., Al₂O₃ or HfO₂, a metal, e.g., TiN or W, or a semiconductor.

In embodiments, chemical reactivity of one of the walls may confine nucleation of two-dimensional materials to occur at said one of the walls. For example, different materials may be used for the first and second wall, wherein one material forms a non-growth surface and the other material forms a growth surface. For example, the first wall may comprise Al₂O₃ and the second wall may comprise SiO₂. As another example, the wall material may comprise an amorphous or crystalline wall material: the first wall may comprise SiO₂ and the second wall may comprise Si.

In embodiments of the first type, the method may further comprise a step c, after step b, of: c) depositing a second wall material on the first set of walls to form a second set of walls, such that a height from a top surface of the second layer to a top of the walls of the second set is from 0.6 nm to 2 nm. In embodiments, step c comprises depositing the second wall material on the first set of walls, selectively with respect to the top surface of the two-dimensional material of the second layer, thereby forming the second set of walls overlying, and aligned with, the first set of walls. In effect, the walls of the second set may form a vertical extension of the walls of the first set. In embodiments, step c comprises performing thermal atomic layer deposition or chemical vapor deposition. It is an advantage of these embodiments that the deposition of the second wall material may be highly selective. In embodiments, the second wall material comprises a dielectric, e.g., Al₂O₃ or HfO₂, a metal, e.g., TiN or W, or a semiconductor. The first and second set of walls may be formed of the same material or of a different material.

Alternatively, step c comprises forming the second set of walls by lithography. In that case, the second set of walls may be overlying, and be aligned with, the first set of walls. However, that is not required. In these embodiments, more freedom may be achieved with respect to tuning of the properties of the walls of the second set, such as: obtaining a different length for the walls of the second set of walls than for the walls of the first set of walls; obtaining a different angle between walls of the second set than between walls of the first set; or obtain a different alignment for the walls of the second set of walls than for the first set of walls, so that a crystal structure of the two-dimensional material of the second layer may have a different orientation than a two-dimensional material of a layer that may be formed, as described below, on the two-dimensional material of the second layer.

A top surface of the second layer may be exposed and define, together with the second set of walls, a further cavity. Steps corresponding to b and c may be repeated alternatingly to form a stack of layers of two-dimensional materials in contact with each other. Concretely, the method may comprise performing, after step c, alternatingly:
forming a two-dimensional material in the further cavity and in physical contact with the exposed top surface of the stack of layers comprising the first and the second layer, and
forming a further set of walls overlying, and aligned with, the existing sets of walls, such that a height from the top surface of the stack of layers to a top of the walls of the further set is from 0.6 nm to 2 nm, thereby forming a further cavity defined by the top surface of the stack of layers and the further set of walls.

In embodiments, at least 50%, preferably at least 60%, more preferably at least 70%, even more preferably at least 80%, yet more preferably at least 90%, by area, of a cross-section of the second layer, parallel to the flat surface, intersects with a single crystal of the two-dimensional material of the second layer, wherein said single crystal contacts the corner of the first set of walls, wherein the single crystal of the two-dimensional material of the first layer and the single crystal of the two-dimensional material of the second layer have a same orientation. These embodiments are typically embodiments wherein at least 50%, by area, of a cross-section of the first layer, parallel to the flat surface, intersects with the single crystal of the two-dimensional material of the first layer, wherein said single crystal of the first layer contacts the corner. The same orientation may result from the angle being adapted to align with the crystal structure of the two-dimensional material of the first layer, e.g., with the single crystal of the first layer, and from the two-dimensional material of the second layer, e.g., the single crystal of the second layer, typically being formed aligned with said corner as well.

In a second type of embodiments, step b comprises non-selectively depositing a second layer of material on the exposed top surface of the first layer and on the first set of walls, thereby forming the second layer comprising a recess overlapping with the first layer. In embodiments, the second layer is a uniform layer covering both the exposed top surface of the first layer and the first set of walls. Said uniformity may relate to the thickness and to the composition of the second layer. In embodiments, the second layer material may be an amorphous dielectric material, e.g., SiO₂. In embodiments, the non-selective deposition may comprise soaking, chemical vapor deposition, or physical vapor deposition, preferably soaking or chemical vapor deposition. Said soaking is a process wherein gas-phase molecules are physisorbed or condensed from the gas-phase onto the exposed top surface to form the second layer of material. Thereby, the second layer of material may cover partly or completely the underlying top surface, depending on the conditions of the soaking, such as a precursor molecule concentration in the reactor used for soaking, static conditions, a pressure in the reactor used for soaking, an exposure time, and a temperature of the first layer when performing said soaking.

In embodiments, the method comprises a step c', after step b, of: c') growing a third layer formed of a two-dimensional material in the recess. Any features of the third layer of the second type of embodiments may independently as correspondingly be described for the second layer of the first type of embodiments.

In preferred embodiments, at least 50%, preferably at least 60%, more preferably at least 70%, even more preferably at least 80%, yet more preferably at least 90%, by area, of a cross-section of the third layer, parallel to the flat surface, intersects with a single crystal of the two-dimensional material of the third layer, wherein said single crystal contacts a corner of the recess, wherein the single crystal of the two-dimensional material of the third layer may have a same orientation as the single crystal of the two-dimensional material of the first layer. As the third layer may be uniform over the first layer and the first set of walls, the recess typically contains a corner of which the orientation and the angle are the same as the orientation and the angle of the corner of the first set of walls. The same orientation may result from the angle of the first set of walls being adapted to align with the crystal structure of the two-dimensional material of the first layer, e.g., with the single crystal of the first layer, and from the two-dimensional material of the second layer, e.g., the single crystal of the second layer, typically being formed aligned with the corner of the recess.

In embodiments, step a comprises: a1) providing the first layer formed of two-dimensional material on the flat surface, wherein a part of the flat surface surrounding the two-dimensional material is exposed, and a2) selectively depositing on the exposed part of the flat surface, selectively with respect to the exposed top surface of the first layer formed of two-dimensional material, a first wall material, thereby forming the walls of the first set. In embodiments, step a2 comprises performing a thermal atomic layer deposition or chemical vapor deposition.

In different embodiments, step a comprises: a1') obtaining a lower part of the first set of walls formed of a first part of the first wall material, comprising a lower part of the first and second wall, in physical contact with the flat surface, and meeting at the corner to form the angle, wherein a top surface of the flat surface is exposed, wherein each of the lower parts of the first set of walls has a length of from 5 nm to 1000 nm, wherein a height of the lower part of the first set of walls, as measured from the exposed top surface of the flat surface to a top of the lower part of the first set of walls, is from 0.6 nm to 2 nm, thereby forming a cavity delimited at least by the top surface and the lower part of the first set of walls. Step a1' may, for instance, comprise deposition of the first part of the first wall material on the flat surface, followed by patterning of the deposited first part of the first wall material so as to form the lower part of the first set of walls. In these embodiments, step a further comprises: a2') forming the first layer in the cavity and in physical contact with the flat surface and with both the lower part of the first and second walls at the corner. In embodiments, step a2' may be performed by chemical vapor deposition or atomic layer deposition. In these embodiments, step a may further comprise: a3') deposition of a second part of the first wall material, selectively with respect to the top surface of the first layer, onto the lower part of the first set of walls so as to form the first set of walls.

In embodiments, the first set of walls comprises a third wall in physical contact with the flat surface, the third wall facing the corner, i.e., the corner of the first set of walls, wherein the shortest distance between the corner and the third wall is at most 1000 nm, wherein the length of the third wall is at least equal to the length of the longest of the first wall and the second wall. In preferred embodiments, the walls of the first set form an enclosure.

In embodiments, a horizontal cross-section, parallel to the flat surface, of each of the walls forms a straight line.

In embodiments, an internal angle between the first wall and the second wall is from 55° to 65° and the two-dimensional material of the first layer has a hexagonal crystal structure. In these embodiments, an internal angle between the second wall and the third wall may be from 55° to 65°, and an internal angle between the first wall and the third wall may be from 55° to 65°.

Without being bound by theory, it is believed that since crystals having a particular, e.g., hexagonal, symmetry are characterized by a particular angle, e.g., an angle of 60°, at the intersections of the in-plane axes of the particular crystalline system, e.g., the three in-plane axes for hexagonal symmetry, the fact that an angle at a corner is close to said particular angle, e.g., 60°, induces the growth of a crystal in that corner and/or induces the seamless coalescence of crystals growing on a same wall or on different walls. This results in a particular alignment of the crystal that is grown.

In other embodiments, an internal angle between the first wall and the second wall may be from 115° to 120° and the two-dimensional material of the first layer has a hexagonal crystal structure. However, in these embodiments, an internal angle between the second wall and the third wall, and an internal angle between the first wall and the third wall will not align with the crystal that is grown.

The angle of the first set of walls is adapted to align with the crystal structure of the two-dimensional material of the first layer. In embodiments, this means that the angle of the first set of walls is equal to the particular angle at the intersections of the in-plane axes of the particular crystalline system of the two-dimensional material of the first layer. Preferably, the orientation of the two-dimensional material of the first layer is identical to what it would be if this material had originally grown from said corner. This may result in a same orientation of the crystal structure of the first layer as the crystal structure of any subsequent layer of a two-dimensional material.

In embodiments, the two-dimensional material of the first layer may be a transition metal dichalcogenide, a transition metal monochalcogenide, a transition metal halide, a transition metal carbide, or a transition metal nitride.

In different embodiments, the internal angle between the first wall and the second wall is from 85° to 95° and the two-dimensional material of the first layer has an orthorhombic crystal structure or a tetragonal crystal structure. In embodiments wherein the two-dimensional material has an orthorhombic crystal structure, the two-dimensional material may be a group IV transition metal monochalcogenides such as tin monosulfide of germanium monosulfide, or vanadium oxide V₂O₅, which is a van der Waals oxide.

In different embodiments, the two-dimensional material of the first layer has a monoclinic crystal structure, that may be described by a lattice structure containing a crystal angle between edges of the unit cell of the monoclinic crystal structure, wherein the internal angle between the first wall and the second wall is equal to said crystal angle with a tolerance of up to 5°. In embodiments wherein the two-dimensional material has a monoclinic crystal structure, the two-dimensional material may be titanium trisulfide or tantalum trisulfide, which are semiconductors.

Said tolerance is preferably up to 4°, more preferably up to 3°, even more preferably up to 2°, still more preferably up to 1°, most preferably 0°.

In embodiments, the method comprises a step d after step b comprising etching the walls of the first set selectively with respect to the second layer. In embodiments comprising the second set of walls, or any further sets of walls, step d may comprise removing the second set of walls, and, if present, any further sets of walls. After removal of the walls, the stack of layers may be ready for further processing. For example, contacts may be provided, connected to each layer comprising a two-dimensional material.

In embodiments, the method comprises a step f, after step b, of recrystallizing the second layer. Recrystallization may be applied to induce a higher level of crystallinity into the second layer. Recrystallization may result in embodiments of the second layer wherein at least 50%, preferably at least 60%, more preferably at least 70%, even more preferably at least 80%, yet more preferably at least 90%, by area, of a cross-section of the second layer, parallel to the flat surface, intersects with a single crystal of the two-dimensional material of the second layer, wherein said single crystal contacts the corner of the first set of walls, wherein the single crystal of the two-dimensional material of the first layer and the single crystal of the two-dimensional material of the second layer have a same orientation. However, the step f of recrystallization is not required, and instead, these embodiments of the second layer may be obtained in step b of forming the second layer.

It is an advantage of the first and the second type of embodiments of the present invention wherein the stack of layers comprises multiple layers of a two-dimensional material, that the formation of crystal grain boundaries may be prevented within each individual layer of a two-dimensional material of the stack.

It is an advantage of the first and the second type of embodiments of the present invention wherein the stack of layers comprises multiple layers of a two-dimensional material, that control over the stacking configuration (e.g., AA' stacking versus AB stacking) between the different layers of a two-dimensional material of the stack may be enabled.

It is an advantage of the first and the second type of embodiments of the present invention wherein the stack of layers comprises multiple layers of a two-dimensional material, that control over the stacking angle between the different layers of a two-dimensional material of the stack may be enabled.

Any features of any embodiment of the first aspect may independently as correspondingly be described for any embodiment of the second aspect of the present invention.

In a second aspect, the present invention relates to a structure comprising:
a flat surface,
a first set of walls, comprising a first wall and a second wall, in physical contact with the flat surface, and meeting at a corner to form an angle, and
a first layer formed of a two-dimensional material in physical contact with the flat surface and with both the first and second walls at the corner,
wherein the angle is adapted to align with the crystal structure of said two-dimensional materials with a tolerance of up to 5°,
wherein each of the walls has a length of from 5 nm to 1000 nm, wherein a height of the walls, as measured from a top surface of the first layer to a top of the walls, is from 0.6 nm to 2 nm, thereby forming a cavity delimited at least by the top surface and the first set of walls, and
a second layer in the cavity and in physical contact with the top surface of the first layer.

Any features of any embodiment of the second aspect may be independently as correspondingly described for the first aspect of the present invention.

### Example 1: Forming a stack comprising a plurality of layers formed of a two-dimensional material

A first example is on an embodiment of the first type of the present invention.

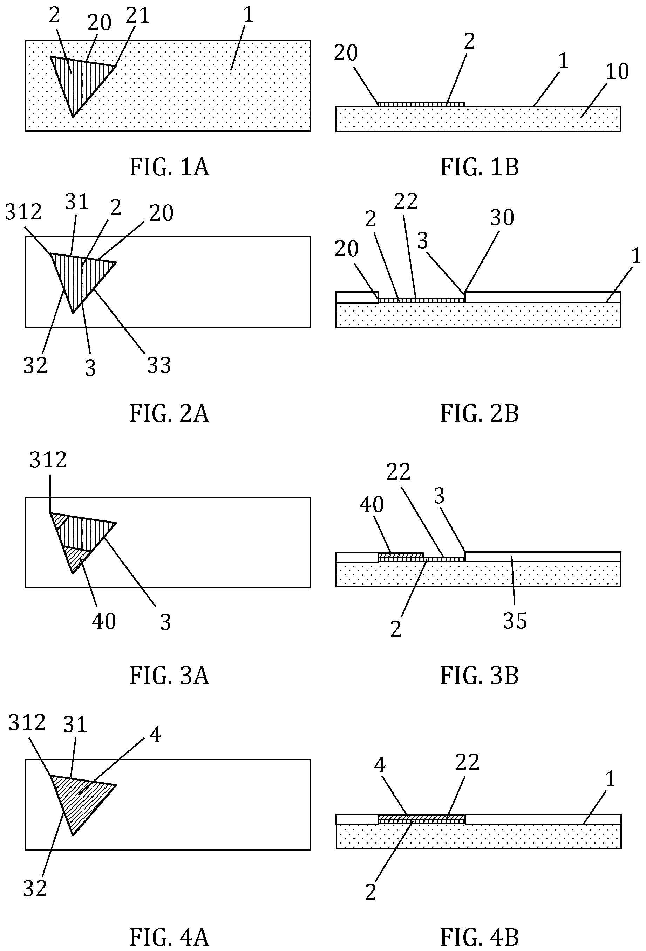

Reference is made to FIG. 1A and FIG. 1B, which show a schematic representation of a top view and a vertical cross-section, respectively, of a flat surface 1 and a first layer 2 formed of a two-dimensional material in physical contact with the flat surface 1. In this example, the flat surface 1 is a top surface of a substrate, e.g., a semiconductor substrate. The first layer 2 formed of a two-dimensional material is parallel to the flat surface 1.

In this example, the first layer 2 has a triangular shape, and comprises three sides 20 each having a same length, that is of from 5 nm to 1000 nm. Each of the three corners 21 of the first layer 2 has an inner angle of 60° with a tolerance of up to 5°. In this example, the two-dimensional material of which the first layer 2 is formed has a hexagonal crystal structure.

In this example, a first wall material is deposited selectively on the flat surface 1, resulting in the top view and the vertical cross-section shown in FIG. 2A and FIG. 2B, respectively. Said deposition is performed selectively with respect to a top surface 22 of the first layer 2. Thereby, the first layer 2 functions as a template for the deposition of the first wall material. As such, the deposited first wall material forms a first set of three walls 3, forming a triangle. The first set of walls 3 comprises, in this example, a first wall 31, a second wall 32 and a third wall 33, each contacting one of the sides 20 of the first layer 2. A height of the walls 3, as measured from the exposed top surface 22 of the first layer 2 to a top 30 of the walls 3, is from 0.6 nm to 2 nm, thereby forming a cavity delimited at least by the top surface 22 of the first layer 2 and the first set of walls 3. The first wall 31 and the second wall 32 meet at a corner 312 to form an angle adapted to align with the crystal structure of the two-dimensional material of the first layer 2 with a tolerance of up to 5°.

For example, the first layer 2 may have been formed within a cavity delimited by a previous set of three walls forming a triangle, located at the same location on the flat surface 1 as now the first set of walls 3, so that the crystal structure of the first layer 2 has been formed aligned with an angle of a corner of the previous set of walls. As a result, the first set of walls 3 being located at the same location as the previous set of walls, the first layer 2 is aligned with the angle of the corner 312 of the first set of walls 3 as well. Alternatively, the first layer 2 may have been formed by patterning so as to arrive at the corner 312 forming the angle adapted to align with the crystal structure of the two-dimensional material of the first layer 2.

Preferably, at least 50%, by area, of a cross-section of the first layer 2, parallel to the flat surface 1, intersects with a single crystal of the two-dimensional material, wherein said single crystal contacts the corner 312. In this example, the first layer 2 forms a single crystal.

In this example, the walls of the first set 3 form an enclosure. The enclosure may ensure that a second layer is formed on the first layer 2. If no enclosure were formed, an attempt at depositing the second layer could result in extending the first layer 2 in a lateral direction, without forming the second layer on top of the first layer 2. The first layer 2 being enclosed between the walls of the first set 3 may prevent a lateral extension of the first layer 2.

Reference is made to the top view and the vertical cross-section shown in FIG. 3A and FIG. 3B, respectively. A second layer is, subsequently, formed, selectively, in the cavity. Typically, a precursor species is deposited, e.g., using atomic layer deposition or chemical vapor deposition, comprising the atoms from which the two-dimensional material of the second layer is to be formed, on the exposed top surface 22 of the first layer 2. The precursor species are selectively deposited with respect to the first wall material 35 containing the first set of walls 3. In this example, the two-dimensional material of the second layer to be formed has a hexagonal crystal structure. The precursor species are adsorbed and may diffuse on the exposed top surface 22 of the first layer 2. The two-dimensional material of the second layer is grown by the diffusing precursor species contacting, and reacting with, each other, forming nuclei 40 which may grow to form the second layer. Due to the limited dimensions of the cavity, the diffusion length of these adsorbed precursor species is smaller than a critical dimension of the cavity, so that only a limited number of nuclei 40, in this example two nuclei 40, are formed. Furthermore, due to the limited dimensions of the cavity, the nuclei 40 are likely to be located at the walls 3 or in one of the corners 312. As a result, the formation of the crystal structure of the second layer may result in alignment of the crystal structure of the second layer with the walls 3 and the corner 312.

Reference is made to the top view and the vertical cross-section shown in FIG. 4A and FIG. 4B, respectively. The second layer 4 is formed in the cavity, in physical contact with the top surface 22 of the first layer 2. The first layer 2 is formed parallel to the second layer 4.

Preferably, at least 50%, by area, of a cross-section of the second layer 4, parallel to the flat surface 1, and parallel to the top surface 22 of the first layer 2, intersects with a single crystal of the two-dimensional material of the second layer, wherein said single crystal contacts the corner 312. In this example, the second layer 4 forms a single crystal. This may result from slow growth of the second layer 4, or from the diffusion length of the precursor species being larger, e.g., at least 10 times as larger, as the critical dimension of the cavity.

Furthermore, this may result from a step of recrystallization of the second layer 4 after its formation. Said recrystallization typically comprises heating, e.g., annealing, of the second layer 4.

Both the crystal structure of the two-dimensional material of the first layer 2, and the crystal structure of the two-dimensional material of the second layer 4, are aligned with respect to the corner 312 formed by the first wall 31 and the second wall 32. Furthermore, the first layer 2 and the second layer 4 have a same, i.e., hexagonal, crystal structure. For example, the first layer 2 and the second layer 4 may be formed of the same material. However, instead, the first layer 2 and the second layer 4 may be formed of different materials that have the same crystal structure. As such, in this example, the single crystal of the two-dimensional material of the first layer 2 and the single crystal of the two-dimensional material of the second layer 4 have a same orientation.

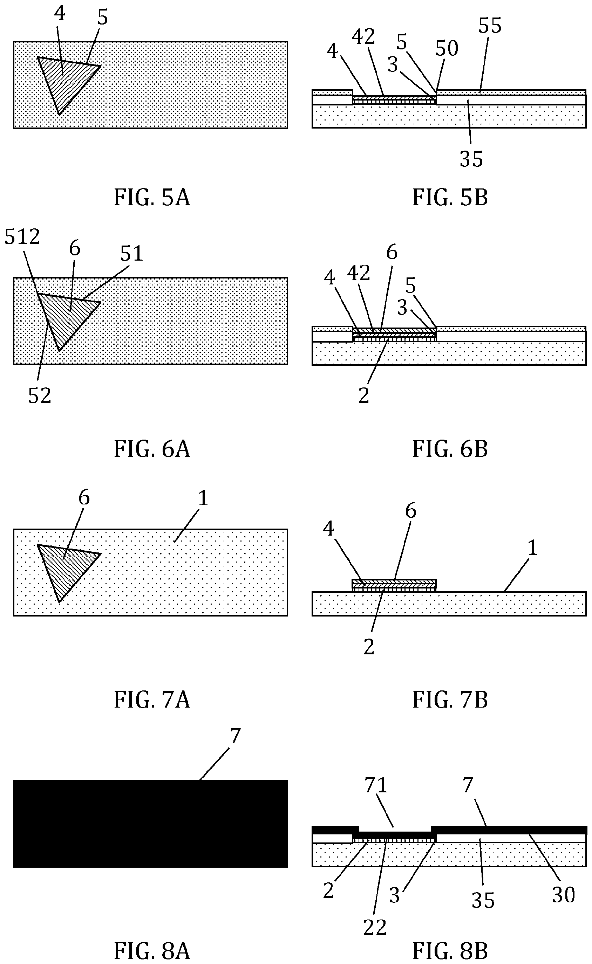

Reference is made to the top view and the vertical cross-section shown in FIG. 5A and FIG. 5B, respectively. After formation of the second layer 4, a second wall material 55 is deposited on the first set of walls 3, i.e., on the first wall material 35 containing the first set of walls 3. The second wall material 55 is deposited selectively with respect to a top surface 42 of the two-dimensional material of the second layer 4. Thereby, a second set of walls 5 overlying, and aligned with, the first set of walls 3 is formed. A height from the top surface 42 of the second layer 4 to a top 50 of the walls of the second set 5 is from 0.6 nm to 2 nm. The walls of the second set 5, and the exposed top surface 42 of the second layer 4 define a cavity.

In effect, in this example, the second set of walls 5 forms an extension to the first set of walls 3.

Reference is made to the top view and the vertical cross-section shown in FIG. 6A and FIG. 6B, respectively. A third layer 6 formed of a two-dimensional material is, subsequently, formed on the top surface 42 of the second layer 4, in the cavity defined by the walls of the second set 5, and the exposed top surface 42 of the second layer 4. In this example, the third layer 6 has a hexagonal crystal structure, and is formed of the same two-dimensional material as the first layer and the second layer 4.

As described above, the crystal structure of the two-dimensional material of the second layer 4 is aligned with respect to the corner formed by the first wall and the second wall of the first set of walls. As the second set of walls 5 overlies, and is aligned with, the first set of walls 3, the second set of walls 5 forms a triangle as well. In this example, the walls of the first set of walls 3 have the same length as the walls of the second set of walls 5. Also, the second set of walls 5 has corners having the same angle as the first set of walls 3. As a result, the crystal structure of the two-dimensional material of the third layer 6 is aligned with respect to the corner 512 formed by a first wall 51 and a second wall 52 of the second set of walls 5, overlying, and aligned with, the corner formed by the first wall and the second wall of the first set of walls 3.

In this example, the single crystal of the two-dimensional material of the second layer 4 and the single crystal of the two-dimensional material of the third layer 6 have a same orientation.

By, alternatingly, repeating the above steps of selectively depositing wall material so as to extend the walls such that a height from a top surface of a top layer of the stack of layers and a top of the walls is from 0.6 nm to 2 nm, then selectively depositing a layer of a two-dimensional material in a cavity defined by the top surface of the top layer of the stack of layers and the walls, a stack of layers, comprising a plurality of layers of a two-dimensional material, of which single crystals have a same orientation, may be formed.

Subsequently, the walls, in this example including the walls of the first set 3 and the walls of the second set 5, may be removed selectively with respect to the stack of layers, including the first layer 2, the second layer 4 and the third layer 6. This may be performed, for example, using a etch for selectively etching the walls. As another example, a hard mask may be applied, covering the stack of layers while exposing the walls, and anisotropic etching may be applied selectively with respect to the hard mask.

In an alternative example, the walls of the second set of walls 5, overlying and aligned with the first set of walls 3, may have a larger length than the first set of walls 3. For removal of the walls of the first 3 and second set of walls 5, in said alternative example, application of the hard mask may be performed, covering the stack of layers while exposing the walls, followed by said anisotropic etching may be applied selectively with respect to the hard mask.

Reference is made to the top view and the vertical cross-section shown in FIG. 7A and FIG. 7B, respectively. This results in the stack of layers, comprising the first layer 2, the second layer 4 and the third layer 6, of which single crystals have a same orientation, on the flat surface 1.

### Example 2: Forming a stack comprising layers formed of a two-dimensional material alternating with layers formed of another material

A second example is on an embodiment of the second type of the present invention.

Reference is made to the top view and the vertical cross-section shown in FIG. 8A and FIG. 8B, respectively. Starting from the first set of walls 3 and the first layer 2 on, i.e., in physical contact with, the flat surface 1, as shown in FIG. 2A and FIG. 2B, in this example, a second layer of material, e.g., an amorphous dielectric material, is non-selectively deposited on the exposed top surface of the first layer 2 and on the first wall material 35 comprising the first set of walls 3, thereby forming the second layer 7 comprising a recess 71 overlapping with the first layer 2.

Typically, as the height of the walls 3, as measured from the top surface 22 of the first layer 2 to a top 30, e.g., top surface, of the walls 3, is from 0.6 nm to 2 nm, the recess 71 has a depth of from 0.6 nm to 2 nm as well. Due to the non-selective deposition, the width of the recess 71 is typically smaller than the width of the first layer 2, typically by a width that is twice as large as the thickness of the deposited second layer 7. For the rest, however, the shape of the recess 71 is typically the same as the cavity delimited at least by the top surface 22 of the first layer 2 and the first set of walls 3. As such, corners of the recess 71 may have a same angle as, and be aligned with, corners of the first set of walls 3.

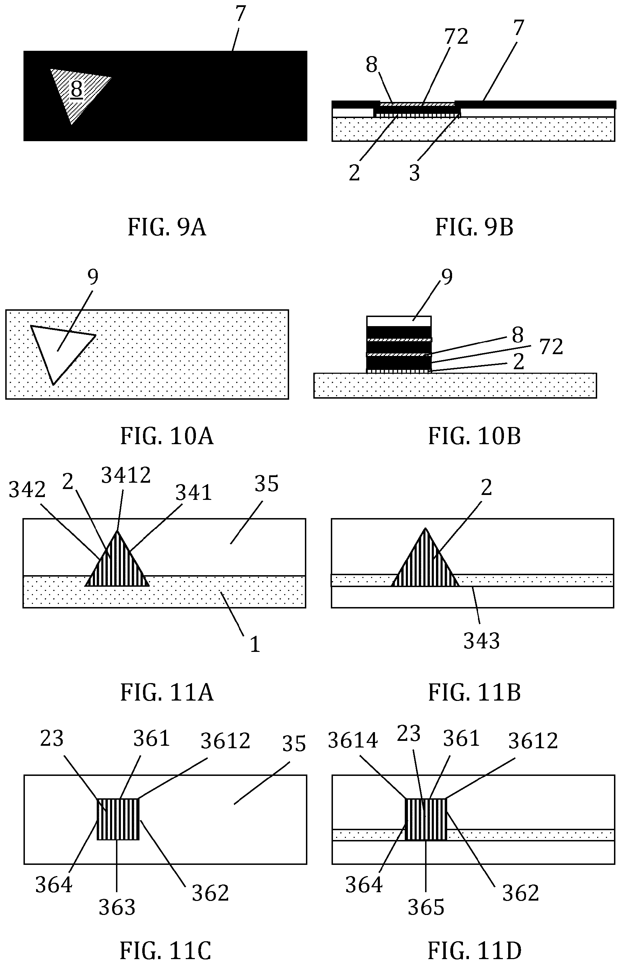

Reference is made to the top view and the vertical cross-section shown in FIG. 9A and FIG. 9B, respectively. A third layer 8 of a two-dimensional material, in this example having a hexagonal crystal structure, is formed in the recess of the second layer 7. A crystal structure of the third layer 8 is aligned with a corner of the recess 71. As the crystal structure of the two-dimensional material of the first layer 2 is aligned with respect to a corner formed of the first set of walls 3, the single crystal of the two-dimensional material of the first layer 2 and the single crystal of the two-dimensional material of the third layer 7 have a same orientation.

The resulting structure comprises a stack of layers comprising the first layer 2 of the two-dimensional material and the third layer 8 of the two-dimensional material, and a part 71 of the layer of non-selectively deposited material 7 sandwiched between the first layer 2 and the third layer 8.

This process of depositing, non-selectively, layers of material, alternatingly with forming layers of a two-dimensional material in the recess of the layers of material, may be repeated several times. Herein, after formation of a layer of a two-dimensional material in a recess, a material, e.g., the same material of which the layers of material are formed, may be selectively deposited on the layer of material, selectively with respect the exposed top surface of the two-dimensional material in the recess. This may be performed so that a height from a top surface of the two-dimensional material to the top surface of the selectively deposited material on the layer of material is from 0.6 nm to 2 nm. Subsequently, a further layer of material may be deposited non-selectively. The selectively deposited material may ensure that the depth of the recess is from 0.6 nm to 2 nm also for subsequently formed layers of material.

Reference is made to the top view and the vertical cross-section shown in FIG. 10A and FIG. 10B, respectively. Subsequently, a hard mask 9 may be formed overlying with the stack of layers comprising the layers of a two-dimensional material comprising at least the first layer 2 and third layer 8, alternated with the part 72 of the layers of non-selectively deposited material. Next, anisotropic etching may be performed, selectively with respect to the hard mask 9.

Although two different examples have been described in accordance with embodiments of the present invention, which relate to the first type of embodiments and the second type of embodiments, respectively, embodiments of the first type and embodiments of the second type may be combined. As one example, a stack of layers in accordance with embodiments of the present invention may contain a plurality of layers of a two-dimensional material on top of each other, formed using a method in accordance with embodiments of the present invention, with a layer of another material, e.g., a dielectric material, on top of the plurality of layers of the two-dimensional material, formed using a method in accordance with embodiments of the present invention, and a further plurality of layers of a two-dimensional material may be formed, using a method in accordance with embodiments of the present invention, on top of the layer of another material.

### Example 3: Alternative shapes formed by the walls

In Example 1 and Example 2, a horizontal cross-section through the first set of walls has the shape of a triangle, i.e., the first set of walls contains three walls forming a triangular enclosure. However, the invention is not limited thereto.

Reference is made to FIG. 11A, which is a top view of a first layer 2 of a two-dimensional material that has a hexagonal crystal structure, on a flat surface 1. A horizontal cross-section through the first layer 2, parallel to the flat surface 1, forms a triangle. Furthermore, a first wall material 35 is provided on the flat surface 1. The first wall material 35 comprises a first set of walls comprising a first wall 341 and a second wall 342, which, in this example, do not form an enclosure. The first layer 2 contacts the first wall 341 and the second wall 342 and the flat surface 1. In this example, the first wall 341 and the second wall 342 meet at a corner 3412 to form an angle, i.e., internal angle, of 60° with a tolerance of up to 5°. However, alternatively, in particular if the crystal structure of the two-dimensional material is different from hexagonal, said angle may be different so as to align with said crystal structure. For example, in case of an orthorhombic crystal structure, said angle could be 90° with a tolerance of up to 5°.

Reference is made to FIG. 11B, which is similar to FIG. 11A, except that the first set of walls further comprises a third wall 343 and the first layer 2 contacts said third wall 343. The third wall 343 faces the corner 3412 where the first wall 341 and the second wall 342 meet. The shortest distance between the corner 3412 and the third wall 343 is at most 1000 nm, and the length of the third wall 343 is at least equal to the length of the longest of the first wall 341 and the second wall 342. The third wall 343 is separated from the first wall 341 and the second wall 342, so that the first set of walls, in this example, does not form an enclosure.

Reference is made to FIG. 11C which is a top view of a first layer 23 of a two-dimensional material that has an orthorhombic crystal structure. A horizontal cross-section, parallel to the flat surface (that is, in this example, completely covered, and thus obscured), through the first layer 23, forms a square. In this example, the first wall material 35 contains four walls 361, 362, 363, 364, each contacting a side of the first layer 23. The four walls 361, 362, 363, 364 form a square having corners having internal angles of 90° with a tolerance of up to 5°, which is adapted to align with the crystal structure of the first layer 23 of this example that is orthorhombic. For example, a first wall 361 and a second wall 362 meet at a corner to form an angle of 90° with a tolerance of up to 5°.

Reference is made to FIG. 11D which is a top view of a first layer 23 of a two-dimensional material that has an orthorhombic crystal structure. In this example, the first wall material 35 contains a first set of walls comprising three walls, comprising a first 361, second 362, and fourth wall 364 each contacting a side of the first layer 23. The first set of walls further comprises a third wall 365 separated from the first 361, second 362 and fourth 364 wall, so that the first set of walls, in this example, does not form an enclosure. The third wall 365 faces a corner 3612 between the first 361 and second wall 362, and a corner 3614 between the first 361 and fourth wall 364. The shortest distance between each of the corners 3612 and 3614 and the third wall 365 is at most 1000 nm, and the length of the third wall 365 is at least equal to the length of the longest of the first wall 361, the second wall 362 and the fourth wall 364. The third wall 365 is separated from the first wall 361, the second wall 362, and the fourth wall 364 so that the first set of walls, in this example, does not form an enclosure.

### Example 4: Forming a nanosheet field effect transistor

Due to the good localization of layers of two-dimensional materials overlying each other, embodiments of the present invention may be used to form nanosheets. In this example, a field effect transistor comprising a nanosheet formed from a stack of layers in accordance with embodiments of the present invention is formed.

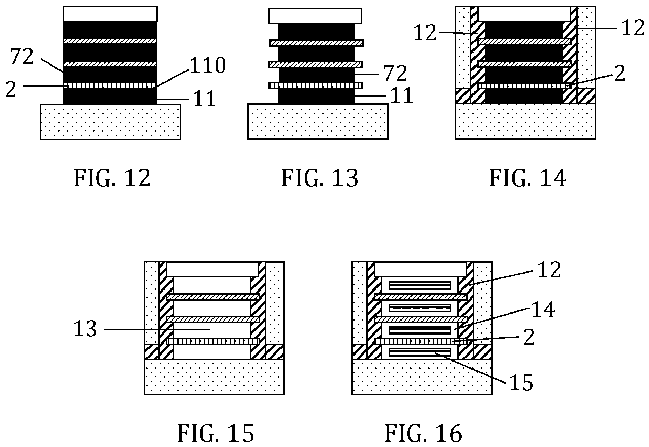

Reference is made to FIG. 12, which is a vertical cross-section of a stack of layers comprising layers formed of a dielectric, sacrificial material 72, alternating with layers formed of a two-dimensional material 2, which may be formed in accordance with embodiments of the second type. Herein, a lowest dielectric, sacrificial layer 11 contains the flat surface 110 in accordance with embodiments of the present invention on which the stack of layers is formed using a method in accordance with embodiments of the present invention.

Reference is made to FIG. 13. The layers formed of a dielectric, sacrificial material 72 and the lowest dielectric, sacrificial layer 11 may be recessed from the sides.

Reference is made to FIG. 14. Contacts 12 may be formed, contacting opposite sides of the layers of two-dimensional material 2 of the stack, forming the source and drain.

Reference is made to FIG. 15. Subsequently, the dielectric, sacrificial material may be removed from the stack of layers by side patterning, forming hollows 13 in the stack.

Reference is made to FIG. 16. Next, surfaces of said hollows may be covered with a layer of gate oxide 14, covering the layers of the two-dimensional material and the contacts 12, and defining, at the center of each of said hollows, a smaller hollow, which may be filled with a gate metal 15, thereby forming a gate stack.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. A method for forming a stack of two or more layers, the method comprising:
a) providing:
a flat surface (1),
a first set of walls (3), comprising a first wall (31) and a second wall (32),
in physical contact with the flat surface (1), and meeting at a corner (312) to form an angle, and
a first layer (2) formed of a two-dimensional material in physical contact with the flat surface (1) and with both the first (31) and second walls (32) at the corner (312),
wherein the angle is adapted to align with the crystal structure of said two-dimensional material with a tolerance of up to 5°,
wherein a top surface (22) of the first layer (2) is exposed,
wherein each of the walls (31, 32) has a length of from 5 nm to 1000 nm, wherein a height of the walls (31, 32), as measured from the exposed top surface (22) of the first layer (2) to a top (30) of the walls (31, 32), is from 0.6 nm to 2 nm, thereby forming a cavity delimited at least by the top surface (22) and the first set of walls (3), then
b) forming a second layer (4, 7) in the cavity and in physical contact with the exposed top surface (22) of the first layer (2).

2. The method in accordance with claim 1, wherein at least 50%, by area, of a cross-section of the first layer, parallel to the flat surface (1), intersects with a single crystal of the two-dimensional material, wherein said single crystal contacts the corner (312).

3. The method in accordance with claim 1 or 2, wherein the second layer (4) is formed of a two-dimensional material, and wherein step b comprises growing the second layer (4) in physical contact with the exposed top surface (22) of the first layer (2), the second layer (4) contacting the first (31) and second wall (32) of the first set (3).

4. The method in accordance with claim 3, further comprising a step c, after step b, of:
c) depositing a second wall material (55) on the first set of walls (3) to form a second set of walls (5), such that a height from the top surface (42) of the second layer (4) to a top (50) of the walls of the second set (5) is from 0.6 nm to 2 nm.

5. The method in accordance with claim 3 or 4, wherein the two-dimensional material of the first (2) and second layer (4) have a same crystal structure.

6. The method in accordance with claim 5 in as far as dependent on claim 2, wherein at least 50%, by area, of a cross-section of the second layer (4), parallel to the flat surface (1), intersects with a single crystal of the two-dimensional material of the second layer (4), wherein said single crystal contacts the corner (312) of the first set of walls (3),
wherein the single crystal of the two-dimensional material of the first layer (2) and the single crystal of the two-dimensional material of the second layer (4) have a same orientation.

7. The method in accordance with any of claims 4 to 6, wherein step c comprises depositing the second wall material on the first set of walls, selectively with respect to the top surface of the two-dimensional material of the second layer, thereby forming the second set of walls overlying, and aligned with, the first set of walls, and wherein step c preferably comprises performing a thermal atomic layer deposition or a chemical vapor deposition of the second wall material.

8. The method in accordance with claim 1 or 2, wherein step b comprises depositing a second layer (7) of material on the exposed top surface (22) of the first layer (2) and on the first set of walls (3), thereby forming the second layer (7) comprising a recess (71) overlapping with the first layer (2).

9. The method in accordance with claim 8, comprising a step c', after step b, of:
c') growing a third layer (8) formed of a two-dimensional material in the recess.

10. The method in accordance with any of the previous claims, wherein step a comprises:
a1) providing the first layer (2) formed of two-dimensional material on the flat surface (1), wherein a part of the flat surface surrounding the two-dimensional material is exposed, and
a2) selectively depositing on the exposed part of the flat surface, selectively with respect to the exposed top surface (22) of the first layer (2) formed of two-dimensional material, a first wall material (35), thereby forming the walls of the first set (3).

11. The method in accordance with any of the previous claims, wherein the first set of walls (3) comprises a third wall (33) in physical contact with the flat surface (1), the third wall (3) facing said corner (312), wherein the shortest distance between the corner (312) and the third wall (33) is at most 1000 nm, wherein the length of the third wall (33) is at least equal to the length of the longest of the first wall (31) and the second wall (32).

12. The method in accordance with claim 11, wherein the walls of the first set (3) form an enclosure.

13. The method in accordance with any of the previous claims, wherein an internal angle between the first wall (31) and the second wall (32) is from 55° to 65° and wherein the two-dimensional material of the first layer (2) has a hexagonal crystal structure, or wherein the internal angle between the first wall (31) and the second wall (32) is from 85° to 95° and the two-dimensional material of the first layer (2) has an orthorhombic crystal structure or a tetragonal crystal structure.

14. The method in accordance with any of the previous claims as depending on claim 3, comprising a step f, after step b, of recrystallizing the second layer (4).

15. A structure comprising:
a flat surface (1),
a first set of walls (3), comprising a first wall (31) and a second wall (32), in physical contact with the flat surface (1), and meeting at a corner (312) to form an angle, and
a first layer (2) formed of a two-dimensional material in physical contact with the flat surface (1) and with both the first (31) and second walls (32) at the corner (312),
wherein the angle is adapted to align with the crystal structure of said two-dimensional material with a tolerance of up to 5°,
wherein each of the walls (31, 32) has a length of from 5 nm to 1000 nm, wherein a height of the walls (31, 32), as measured from a top surface (22) of the first layer (2) to a top (30) of the walls (3), is from 0.6 nm to 2 nm, thereby forming a cavity delimited at least by the top surface (22) and the first set of walls (3), and
a second layer (4, 7) in the cavity and in physical contact with the top surface (22) of the first layer (2).
